# EUROPEAN PATENT SPECIFICATION

(11) **EP 4 116 673 B1**
(45) Date of publication and mention of the grant of the patent: **17.09.2025**
(21) Application number: 22177272.6
(22) Date of filing: 03.06.2022
(51) Int. Cl.: G01C 21/00, G01S 5/02, G06N 3/00, H04B 17/318, H04W 4/00, H04B 17/373

(54) **A SERVER DEVICE AND A METHOD FOR SPATIAL MAPPING OF A MODEL**
SERVERVORRICHTUNG UND VERFAHREN ZUM RÄUMLICHEN ABBILDEN EINES MODELLS
DISPOSITIF DE SERVEUR ET PROCÉDÉ DE CARTOGRAPHIE SPATIALE D'UN MODÈLE

(30) Priority: 07.07.2021 SE 2150902
(43) Date of publication of application: 11.01.2023
(73) Proprietor: Sony Group Corporation, Tokyo 108-0075 (JP)
(72) Inventor: EXNER, Peter, Hampshire, RG22 4SB (GB); BERGKVIST, Hannes, Hampshire, RG22 4SB (GB)
(74) Representative: Aera A/S

(56) References cited:
- CN-A- 111 817 805
- US-B1- 10 959 109

## Description

### TECHNICAL FIELD

The present disclosure pertains to the field of Internet of things (IoT) and relates to a server device for spatial mapping of a model.

### BACKGROUND

Today, many electronic devices, such as IoT devices, are used for different tasks, such as tracking and/or reporting data. Models, such as machine learning models, may be used to optimize the operation of electronic devices in a certain area, such as geographical area. However, it may be difficult to determine which model and/or which capacity of model to use.

CN 111817805A describes a method and a device for adjusting channel propagation model parameters and a medium. The method comprises the following steps: acquiring initial feature data between transceiving nodes in a modeling area; processing the initial feature data according to processing rules corresponding to different data types to obtain feature information and an empirical model prediction value; and combining the initial feature data, the feature information and the empirical model prediction value as an initial input feature set; encoding the initial input feature set to obtain an input feature set; and adjusting each coded data contained in the input feature set by using a simulated annealing algorithm to obtain a target input feature set matched with the modeling area. Feature screening is carried out on the input characteristic set according to the simulated annealing algorithm, irrelevant and redundant input features can be effectively removed, the situation that prediction errors are increased due to the fact that the wireless propagation model is excessively fitted to irrelevant data is avoided, and the prediction accuracy of the wireless propagation model in different scenes is improved.

### SUMMARY

There may be multiple ways to provide a model for an area. Some areas are dense and require finer granularity. Other areas are more uniform over a larger space, such as for a field, such as a field of crops. However, it may be difficult to determine which model and/or which capacity of model to use for which area.

Accordingly, there is a need for server devices and methods for spatial mapping of a model, which may mitigate, alleviate, or address the shortcomings existing and may provide an improved model allocation for a certain area, in a power-efficient manner, and with improved allocation of capacity.

A server device is provided according to claim 1.

The disclosed server device may provide an improved allocation of a model for an area (such as geographical area), in a power-efficient manner, and with improved available capacity of the allocated model. In other words, the capacity of the model selected for an electronic device is improved by the present disclosure. It may be appreciated that the present disclosure provides an improved usage of resources of the electronic device that is configured to execute and/or run the model. For example, a density of models may be improved (such as improving a geographical coverage of a model for an electronic device). In other words, the disclosed server device and related method may adapt the size of an area (such as map splitting) depending on a capacity of a model and/or resources of the electronic device that is configured to execute and/or run the model. In other words, the disclosed server device and related method may adapt a size of an area to a model based on characteristics of the area. The disclosed server device and related method may adapt a size of an area to a model based on characteristics of the area in an iterative manner.

It is an advantage of the present disclosure that an improved performance of a model for a given area may be achieved. The present disclosure may provide a spatial mapping of a model, such as based on a performance of the model. An advantage of the present disclosure is therefore that an improved spatial mapping (such as improved area division) is provided. For example, optimal boundaries of a geographical area given a fixed sized model may be provided. In other words, the present disclosure may improve a performance of a model resulting from a determination of a second area that is division of a first area and a subsequent training and/or re-training of a model assigned to the second area.

### BRIEF DESCRIPTION OF THE DRAWINGS

The above and other features and advantages of the present disclosure will become readily apparent to those skilled in the art by the following detailed description of examples thereof with reference to the attached drawings, in which:
Fig. 1 is a diagram illustrating an example system comprising an example server device according to this disclosure and an example electronic device,
Fig. 2 is a block diagram illustrating an example server device according to this disclosure,
Figs. 3A-3C is a flow-chart illustrating an example method, performed in a server device according to this disclosure,
Fig. 4A is a schematic representation illustrating an example of obtaining a first model for a first area according to this disclosure,
Fig. 4B is a schematic representation illustrating an example of a determination of a second area by applying encoding to the second area, and
Fig. 4C is a schematic representation illustrating an example of a determination of a second area according to this disclosure.

### DETAILED DESCRIPTION

Various examples and details are described hereinafter, with reference to the figures when relevant. It should be noted that the figures may or may not be drawn to scale and that elements of similar structures or functions are represented by like reference numerals throughout the figures. It should also be noted that the figures are only intended to facilitate the description of the examples. They are not intended as an exhaustive description of the disclosure or as a limitation on the scope of the disclosure. In addition, an illustrated example needs not have all the aspects or advantages shown. An aspect or an advantage described in conjunction with a particular example is not necessarily limited to that example and can be practiced in any other examples even if not so illustrated, or if not so explicitly described.

The figures are schematic and simplified for clarity, and they merely show details which aid understanding the disclosure, while other details have been left out. Throughout, the same reference numerals are used for identical or corresponding parts.

An approach where a division of a large area into a set of smaller areas may result in a sub-optimal division of areas, since certain areas may be more complex than other areas. For example, an area with a dense urban environment may require a finer grained division than an area with an open field with a less complex environment that may not require to be divided. For example, an area with a dense urban environment may require refining a spatial mapping of a geographical area represented by one or more models, for example based on a performance of the one or more models.

There is a need for server devices and methods that provide a performance-based spatial mapping of a model for operating an electronic device in an area.

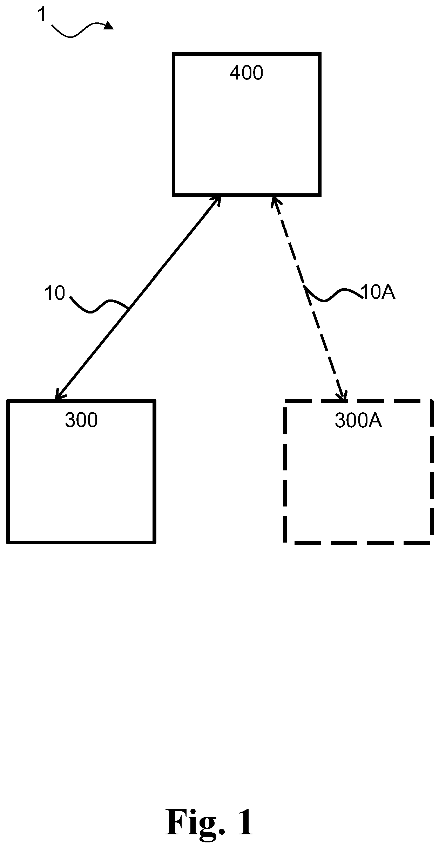

Fig. 1 is a diagram illustrating a spatial mapping system 1 comprising an example server device 400 according to this disclosure, an example electronic device 300, and optionally an example electronic device 300A. The spatial mapping system 1 may be seen as an asset monitoring system, for example by monitoring one or more parameters measured by one or more electronic devices (such as 300 and/or 300A). The spatial mapping system 1 may for example be seen as an electronic device (such as IoT device) monitoring system, such as a farming monitoring system and/or a tracking monitoring system.

As discussed in detail herein, the present disclosure relates to a spatial mapping system 1 (such as using wireless communication). The spatial mapping system 1 may use a cellular system, for example, a 3GPP wireless communication system and/or the internet, and/or a local communication system, such as short-range wireless communications systems, such as Wi-Fi, Bluetooth, Zigbee, IEEE 802.11, IEEE 802.15.

The spatial mapping system 1 may optionally comprise a network node (such as a base station, not shown) that the server device 400 and the electronic devices 300, 300A may communicate through. A network node refers to a radio access network node operating in the radio access network, such as a base station, an evolved Node B, eNB, gNB in NR. In one or more examples, the RAN node is a functional unit which may be distributed in several physical units.

The server device 400 may be seen as a device configured to act as a server in communication with a client device, where the electronic device (300, 300A) is configured to act as a client.

The server device 400 may be configured to communicate with the electronic device 300 via a link 10, such as wired and/or wireless link.

The server device 400 may be configured to communicate with the electronic device 300A via a link 10A, such as wired and/or wireless link.

The server device 400 comprises memory circuitry, one or more interfaces, and processor circuitry. The server device 400 is configured to obtain a first model for a first area. The server device 400 is configured to obtain first operational data associated with the first area, from one or more first electronic devices (such as electronic devices 300, 300A). The server device 400 may be configured to obtain operational data from at least 5, at least 10, at least 20, at least 50, and/or at least 100 electronic devices. The server device 400 is configured to determine a second model, based on the first operational data and the first model. The server device 400 is configured to obtain a first performance parameter indicative of a performance of the first model. The server device 400 is configured to obtain a second performance parameter indicative of a performance of the second model. The server device 400 is configured to determine a model performance parameter based on the first performance parameter and the second performance parameter. The server device 400 is configured to determine whether the model performance parameter satisfies a first criterion. The server device 400 is configured to, when the model performance parameter does not satisfy the first criterion, determine whether the second performance parameter satisfies a second criterion. The server device 400 is configured to, when the second performance parameter does not satisfy the second criterion, determine a second area, the second area being smaller than the first area; and obtain a third model for the second area.

A model as referred to herein (such as the first model, second model, third model, and/or fourth model) may be seen as a model and/or a scheme and/or a mechanism and/or a method configured to provide, based on operational data and/or a previous model, one or more configurations of one or more operational parameters, such as of an operation scheme for one or more electronic devices located in an area. A model as referred to herein (such as the first model, second model, third model, and/or fourth model) may be based on the same model architecture. A model architecture may be based on a neural network, such as comprising one or more different type of layers and/or number of layers. A model architecture may be seen as configuration of a model, such as comprising one or more parameters of a model. For example, a model architecture may comprise a configuration indicating one or more of: a type of model, a size of model, connections between neurons, an input of a model, and an output of a model. A model architecture may comprise a neural network comprising one or more of a feed forward neural network, a long short-term memory network, LSTM, and a convolutional neural network, CNN. Example of models include operational model for one or more electronic devices in an area (such as a transmission power model, a model for activating a sensor and/or actuator) and/or a spatial model for operations of the one or more electronic devices in an area.

**In** one or more example server devices, the model as referred to herein may be stored on a non-transitory storage medium (for example, memory circuitry 401). The model may be stored on a non-transitory storage medium of the server device 400 being configured to execute the model. **In** one or more example server devices, the model may comprise model data and or computer readable instructions (for example based on operational data, such as historical operational data). The model data and/or the computer readable instructions may be used by the server device and/or the one or more electronic devices.

The model (such as model data and/or the computer readable instructions) may be used by the server device and/or the one or more electronic devices to monitor, control, and/or operate electronic devices (such as IoT devices). In other words, the model (such as model data and/or the computer readable instructions) may be used by the server device and/or the one or more electronic devices to monitor, control, and/or operate electronic devices (such as IoT devices) over a given area. In other words, the model may comprise pre-stored model data indicative of one or more configurations, such as indicative of one or more operational parameters. The server device and/or the electronic device may be configured to determine, based the model (which comprises the model data), an operation scheme (such as the operation scheme comprising one or more operation configurations which may comprise one or more operation parameters). In one or more examples, the model is configured to provide a set of coefficients. The set of coefficients is configured to characterize an area in terms of operational parameter(s), such as to characterize operation parameter(s) associated with a spatial point of the area. For example, the set of coefficients is configured to characterize transmission power parameter(s) associated with a spatial point of the area. For example, the set of coefficients is configured to characterize power usage parameter(s) (such as transmission power) associated with a spatial point of the area, depending on radio conditions of spatial point of the area. Radio conditions may vary across an area and/or over time. In other words, the set of coefficients may for example have different transmission power parameters for the same area. The model may be configured to output the set of coefficients to one or more electronic devices of an area. For example, the set of coefficients is configured to characterize sensor/actuator(s) activation parameter(s) associated with a spatial point of the area. A set of coefficients of the model may be updated when the model is updated. A coefficient may be seen as a weight of the model.

A capacity of a model as described herein, may be seen as a size of the model, such as the number of coefficients used in the model to characterize an area. For example, the coefficients may be stored on an electronic device configured to execute the model. The capacity of a model can relate to a precision and/or an accuracy of the modelling of an area, such as of the characterization of an area by the model. For example, the capacity of a model for an area which is seen as homogeneous (such as fields of agriculture), may be lower than the capacity of a model for an area which is dense and heterogeneous (such as an urban area).

A model density may be seen as a number of models per area, for example when dividing an area into smaller areas and assigning a model to each smaller area.

Resources of an electronic device operating the model may be seen as related to memory, processing and/or battery and/or the like. For example, memory resources may be a limit of 100 kilobyte, kb, 200 kb or the like. For example, resource constraints of an electronic device may limit the available model capacity that may be executed by an electronic device.

It may be appreciated that there may be a trade-off between an accuracy of a model and resources of an electronic device configured to execute the model.

An electronic device (such as electronic devices 300, 300A) may be seen as an IoT device (such as a tracking device and/or a reporting device) in communication with the server device 400. An electronic device may be seen as a wireless device, such as a mobile device and/or user equipment. The electronic devices 300, 300A may comprise memory circuitry, a wireless interface, and processor circuitry. The electronic devices 300, 300A may comprise or be connectable to one or more sensor devices (not shown, such as for measuring one or more parameters, for example sensor data, radio parameter data, position data, movement data, temperature data, image data, and/or light data) and/or one or more actuators (or connectable to actuators). For example, actuators may comprise spraying equipment for an agricultural field, arrangements for controlling light, and/or irrigation, dispensing fertiliser.

The electronic device 300 may be configured to output (such as via link 10A, for example a wireless communication link and/or a wired link), operational data (such as first operational data and/or second operational data) to the server device 400.

The server device 400 may be configured to output (such as via link 10A, for example a wireless communication link and/or a wired link), the first model, the third model, and/or the fourth model to the one or more electronic devices (such as electronic devices 300, 300A).

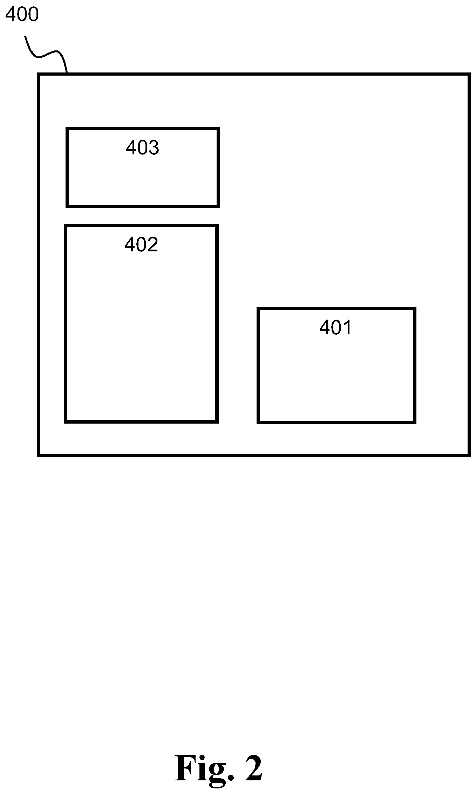

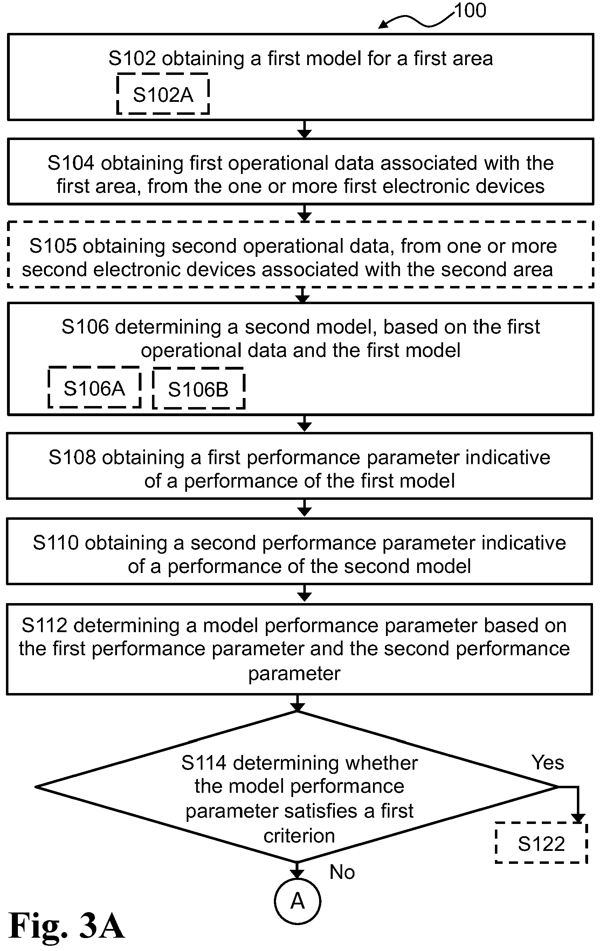

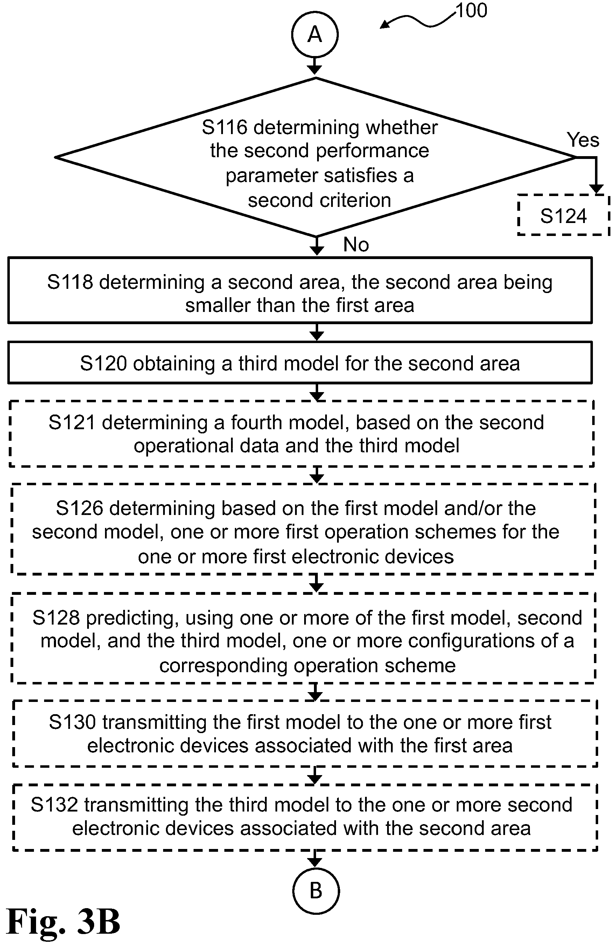

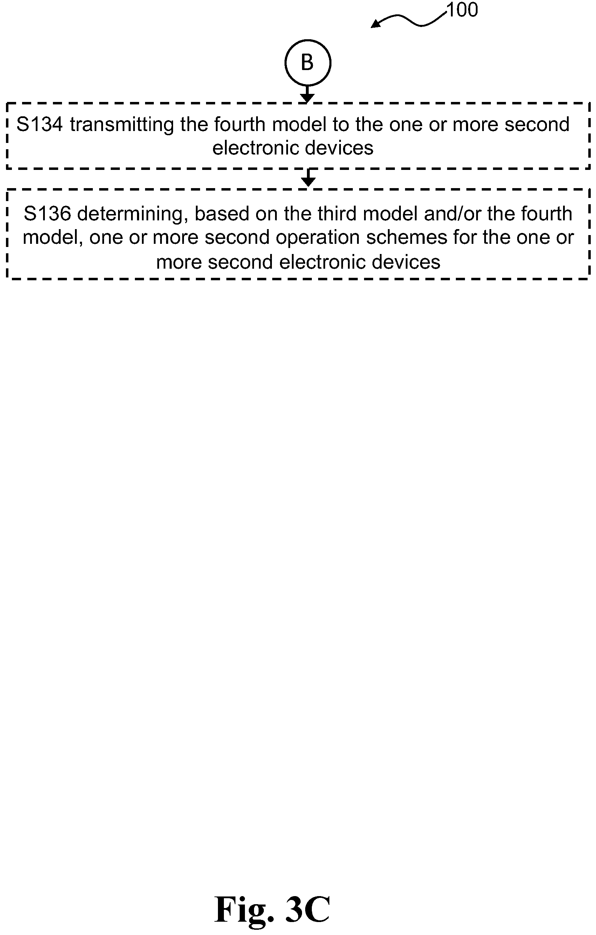

Fig. 2 shows a block diagram of an example server device 400 according to the disclosure. The server device 400 comprises memory circuitry 401, processor circuitry 402, and a wireless interface 403. The server device 400 may be configured to perform any of the methods disclosed in Figs. 3A-3B. In other words, the server device 400 may be configured for spatial mapping of a model, such as a model for operational parameters of an electronic device. For example, the server device 400 may be configured to associate (such as assign and/or allocate) a model to an area (such as assign a model to an area of a certain size) based on a performance of a model and/or based on operational data associated with an area. The server device 400 may be implemented in a network, such as in a cloud-based architecture. For example, the server may be a cloud server.

The server device 400 is configured to obtain (such as receive, determine, generate and/or retrieve), such as using the processor circuitry 402 and/or via the wireless interface 403, a first model for a first area.

An area (such as first area, second area, third area) may comprise one or more of a set of coordinates (such as corresponding to the area), a point of interest, POI, a building, a map feature, a street, a route, a country, a city, a town, and a highway. An area as described herein may comprise a geographical area, a geospatial area, a geographical region/point of interest, and/or a map feature. In other words, the first area may comprise a first set of coordinates corresponding to the first area. The first area may for example correspond to the area of a city. To obtain a first model for a first area may comprise to assign a first model to a first area (such as assign a first model to a first size of area). To obtain a first model for a first area may comprise to receive and/or retrieve the first model from a memory (such as the memory circuitry 401, for example the first model being preassigned a first area). In one or more example server devices and/or electronic devices, the obtaining of the first model is based on an association of the first model with the first area (such as with the first set of coordinates). An area may comprise a level of complexity depending on or more parameters. The level of complexity of an area may depend on one or more parameters affecting for example the radio conditions in the area. For example, a level of complexity of an area may depend on a terrain of an area, a building density, and/or a population density. For example, an area comprising many sloped and/or rocky parts may be more complex to model than a flat area. In one or more example server devices, the server device 400 is configured to transmit (such as sending using the processor circuitry 402 and/or via the wireless interface 403) the first model to the one or more electronic devices (such as electronic devices 300, 300A of Fig. 1) associated with the first area. In other words, the server device 400 may be configured to distribute the first model to the one or more electronic devices associated with the first area.

**In** one or more example electronic devices, the electronic device is configured to receive the first model. **In** one or more example electronic devices, the electronic device is configured to have the first model pre-loaded (such as installed on the one or more electronic devices' firmware).

The server device 400 is configured to obtain (such as receive, determine, generate and/or retrieve), such as using the processor circuitry 402 and/or via the wireless interface 403, first operational data associated with the first area (such as associated with a first set of coordinates), from the one or more first electronic devices (such as electronic device 300 and/or 300A of Fig. 1). Operational data as described herein may be seen as data (such as one or more measurements from one or more sensor devices of the one or more electronic devices). First operational data associated with the first area may be seen as operational data being indicative of one or more conditions of one or more parameters for the one or more first electronic devices in the first area. For example, the first operational data associated with the first area may be indicative of a radio condition of the one or more electronic devices in the first area. For example, in certain areas where radio conditions are poor, a large amount of transmission power (such as transmitting energy) may be consumed by an electronic device by searching, connecting, and/or transmitting. The present disclosure may therefore provide a more power efficient operation of electronic devices (for example by predicting, such as forecasting transmission power based on sensed radio conditions).

In one or more example server devices, the first operational data comprises sensor data and/or radio parameter data. The radio parameter data may for example comprise sensed radio conditions (such as signal strength and/or transmission power) by the one or more electronic devices in the first area. The radio parameter data may comprise a signal strength indicator (such as level and/or intensity), a channel quality indicator, CQI, a timing advance value, an error rate parameter, and a difference in signal strength. The radio parameter data may comprise a signal-to-interference-plus-noise ratio, SINR, a reference signal received power, RSRP, a reference signal received quality, RSRQ, and/or a timing advance value, TA. A signal strength indicator may for example comprise a received signal strength indication, RSSI, and/or channel state information, CSI. An error rate parameter may for example comprise a bit error rate, BER, a frame error rate, FER, and/or a block error rate, BLER. The sensor data may comprise one or more of position data (such as tuples of coordinates), movement data, temperature data, and/or light data.

The server device 400 is configured to determine a second model, such as using the processor circuitry 402, based on the first operational data and/or the first model. **In** other words, the server device 400 (such as a cloud server) may be configured to update the first model for the first area based on the first operational data associated with the first area. For example, the server device 400 may be configured to update the first model for the first area based on the first operational data associated with the first set of coordinates to provide the second model, such as based on the first operational data from the one or more first electronic devices. The second model may be seen as an updated first model, such as a trained and/or re-trained first model.

In one or more example server devices, the determination of the second model is based on a training and/or re-training of the first model. In other words, the server device 400 may be configured to train and/or re-train the first model based on the first operational data. For example, the server device 400 may determine the second model by training and/or re-training the first model, to predict (such as forecasting) second operational data (such as updated first operational data) based on the first operational data.

In one or more example server devices, the determination of the second model is based on the sensor data and/or radio parameter data. The server device 400 may for example predict second operational data (such as predicted transmission power) based the sensor data and/or the radio parameter data (such as sensed radio conditions).

The server device 400 is configured to obtain (such as receive, determine, generate and/or retrieve), such as by using the processor circuitry 402 and/or via the wireless interface 403, a first performance parameter indicative of a performance of the first model. To obtain a first performance parameter may comprise to obtain a performance indicator, such as a first performance indicator.

The first performance parameter may be seen as a parameter indicative of a performance of the first model. The first performance parameter may comprise a first performance indicator, for example being indicative of an accuracy of the first model (such as an accuracy of a prediction of the first model). The first performance parameter may comprise a score, such as a first score of the first model. The first performance parameter may be based on one or more of: a mean square error (such as for regression tasks), an outlier mitigation, a classification model (such as F1-score rate, for example using cross-entropy for classification tasks), a regression model, and a loss function (such as indicating an inverted performance graph, where a lower value indicates a better model). The first performance parameter may be indicative of a first batch (B1) with a first accuracy (A1). The first batch (B1) may refer to and/or be indicative of the operational data, such as sensor data and/or radio parameter data.

F1-score rate may be seen as a measure of accuracy of the model. For example, F1-score rate may be calculated based on a precision parameter and a recall parameter of the model, where the precision parameter may be the number of true positive results divided by the number of all positive results, including those not identified correctly, and the recall parameter may be the number of true positive results divided by the number of all samples that should have been identified as positive. The precision parameter may be seen as a positive predictive value, and the recall parameter may be seen as sensitivity in diagnostic binary classification. F1-score rate may be seen as F-score and/or F-measure.

The server device 400 is configured to obtain (such as receive, determine, generate and/or retrieve), such as by using the processor circuitry 402 and/or via the wireless interface 403, a second performance parameter indicative of a performance of the second model. For example, the second model may be based on training or retraining the first model. To obtain a second performance parameter may comprise to obtain a performance indicator, such as a second performance indicator.

The second performance parameter may be seen as a parameter indicative of a performance of the second model. The second performance parameter may comprise a second performance indicator, for example being indicative of an accuracy of the second model (such as an accuracy of a prediction of the second model). The second performance parameter may comprise a score, such as a second score of the second model. The second performance parameter may be based on one or more of: a mean square error, an outlier mitigation, a classification model (such as F1-score rate), a regression model, and a loss function (such as indicating an inverted performance graph, where a lower value indicates a better model). The second performance parameter may be indicative a second batch (B2) with a second accuracy (A2), wherein the first model has been retrained between the first batch and the second batch, to provide the second model.

The server device 400 is configured to determine (such as by using the processor circuitry 402) a model performance parameter based on the first performance parameter and the second performance parameter. For example, the model performance parameter may comprise a performance delta, such as a comparison between the second performance parameter and the first performance parameter. The server device 400 may be configured to determine a difference (such as a subtraction) between the second performance parameter and the first performance parameter (such as A2-A1). **In** other words, the model performance parameter may be indicative of how much the accuracy of a model (such as the second model compared to the first model) has increased and/or not increased (such as plateaued and/or stabilized) after a training and/or re-training. The model performance parameter may be indicative of improvement or stagnation of a performance of the second model (such as updated first model) compared to the performance of the first model. The model performance parameter may comprise a score, such as a model score of the second model in comparison with the first model. The model performance parameter may comprise a model performance indicator, for example being indicative of a difference in accuracy between the second model and the first model.

The model performance parameter may be based on one or more of: a mean square error, an outlier mitigation, a classification model (such as F1-score rate), a regression model, and a loss function (such as indicating an inverted performance graph, where a lower value indicates a better model).

The server device 400 is configured to determine (such as by using the processor circuitry 402) whether the model performance parameter satisfies a first criterion (such as indicative of a capacity of a model). In other words, the first criterion may be indicative of a capacity of a model in combination with a task of the model (such as one or more configurations of one or more operational parameters).

In one or more example server devices, the first criterion comprises a first threshold. In one or more example server devices, the determination of whether the model performance parameter satisfies the first criterion is based on determining whether the model performance parameter is above the first threshold, such as determining whether the model performance score is above the first threshold. For example, the server device may be configured to determine whether the model performance parameter (such as the model performance parameter associated with the second model in comparison to the first model) satisfies a first criterion. For example, the server device may be configured to determine whether the model performance parameter (such as the model performance score associated with the second model in comparison to the first model) is above a threshold, such as a first threshold.

In one or more example server devices, the server device 400 (such as using the processor circuitry 402) is configured to, when the model performance parameter satisfies the first criterion, refrain from determining whether the second performance parameter satisfies a second criterion. In other words, the performance of the first model may be sufficient for the first area. For example, the first model may have sufficient capacity to model the complexity of the first area (such as the first model having an appropriate capacity for the size of the first area, for example having capacity to cover more details of the first area). In other words, the first model may have a correct spatial coverage for the first area. For example, the present disclosure may provide a determination of a second area that is division of the first area for a model and/or an electronic device having limited resources (such as determination of a spatial area that a fixed size model may be able to represent with a sufficient resolution and/or accuracy). For example, optimal boundaries of a geographical area given a fixed size model may be provided.

The server device 400 is configured to determine (such as by using the processor circuitry 402), when the model performance parameter does not satisfy the first criterion, whether the second performance parameter satisfies a second criterion. In other words, the server device 400 is configured to proceed to determining whether the second performance parameter satisfies a second criterion, when the model performance parameter does not satisfy the first criterion. The server device 400 may determine that the second model has plateaued (for example, the second model has reached a plateau of the second performance parameter, such as tending towards a logarithmic limit), when the model performance parameter does not satisfy the first criterion. In one or more example server devices, the server device 400 may determine that the first mode has plateaued. In one or more example server devices, the server device 400 may determine that any subsequent model (such as a third model, a fourth model etc.) has plateaued.

In one or more example server devices, the second criterion comprises a second threshold. In one or more example server devices, the determination of whether the second performance parameter satisfies the second criterion is based on determining whether the second performance parameter is above the second threshold, such as determining whether the second performance score is above the second threshold. For example, the server device may be configured to determine whether the second performance parameter (such as the second performance parameter associated with the second model) satisfies a second criterion. For example, the server device may be configured to determine whether the second performance parameter (such as the second performance parameter associated with the second model) is above a threshold, such as a second threshold. The second threshold may be different from the first threshold. In other words, the server device 400 may be configured to determine whether the performance of the second model (such as updated first model) is already above a threshold (such as the second threshold).

The determination of whether the model performance parameter satisfies the first criterion and the determination of whether the second performance parameter satisfies the second criterion may be performed in any order.

In one or more example server devices, the model performance parameter does not satisfy the first criterion when the model performance parameter is equal to or below the first threshold. For example, the first threshold may comprise any value(s) between 0 and 1. For example, the first threshold may be 0.10, 0.05, and/or 0.01. For example, when the model performance parameter is above a first threshold of 0.10, the performance delta between the first performance parameter and the second performance parameter is above 10% (such as an improvement in accuracy of 10%). In other words, the performance of the second model may be more than 10% better than the performance of the first model.

The server device 400 is configured to determine a second area (such as by using the processor circuitry 402), when the second performance parameter does not satisfy the second criterion. The second area is smaller than the first area. For example, when the first area corresponds to a city, the second area may correspond to a sub-part of the first area, such as a sub-part of a city. To determine the second area may comprise to divide (such as split, such as split geographically) the first area into one or more smaller areas, such as including the second area. In one or more example server devices, the server device 400 (such as using the processor circuitry 402) may be configured to determine one or more sub-areas (such as including the second area) of the first area, the one or more sub-areas being smaller than the first area. The one or more sub-areas may comprise at least 5 areas, at least 10 areas, at least 20 areas, at least 50 areas, at least 100 areas, at least 500 areas. In one or more example server devices, the second area is part of a plurality of areas (such as one or more areas including the second area) included in the first area. The server device 400 may for each of the plurality of areas, be configured to determine a corresponding set of coordinates, each area being smaller than the first area. The server device 400 may be configured to obtain a corresponding model for the corresponding set of coordinates (such as corresponding to each area, for example associate a corresponding model). The server device 400 may be configured to determine the second area based on one or more of: the first area, the first operational data, the first performance parameter, the second performance parameter, and the model performance parameter. For example, the server device 400 may determine, when the second model has plateaued for the first area, a second area being smaller than the first area. In other words, the server device 400 may decrease, when the second model has plateaued for the first area, a size of an area that the first area is divided into.

In one or more example server devices, the second performance parameter does not satisfy the second criterion when the second performance parameter is equal to or below the second threshold, such as when the second performance score is equal to or below the second threshold. When the second performance parameter does not satisfy the second criterion, the capacity of the second model may be considered as saturated. In other words, the first area may be too complex for the capacity of the second model. For example, when the second performance parameter does not satisfy the second criterion, it may not be possible to improve the performance of the second model for the first area (such as the accuracy of the second model for the first area may not be satisfactory based on the second criterion). In other words, the performance of the second model may be seen as having plateaued. For example, the second threshold may comprise any value(s) between 0 and 1. For example, the second threshold may be 0.60, 0.65, 0.70, 0.75, 0.80, 0.85, 0.90, and/or 0.95. For example, when the second performance parameter is above a second threshold of 0.60, the performance of the second model is above 60% better (such as an improvement in accuracy of 60%) than the performance of the previous model (such as the latest model).

In one or more example server devices, the determination of the second area comprises applying one or more of: clustering one or more elements of the first area and encoding the second area into an alphanumeric string. In other words, the server device 400 may be configured to cluster one or more elements of the first area, such as coordinates of the first area, to provide a plurality of areas (such as including the second area, for example sub-areas). Clustering may be used a guide on how to split the first area. To encode the second area into an alphanumeric string may comprise to apply a geohashing function. The server device 400 may be configured to divide the first area into one or more clusters.

In one or more example server devices, the server device 400 (such as using the processor circuitry 402) is configured to, when the second performance parameter satisfies the second criterion, refrain from determining the second area. In other words, the performance of the second model may be sufficient for the first area. In other words, the first area does not need to be divided in smaller areas. For example, the second model may have sufficient capacity to model the complexity of the first area (such as the second model having an appropriate capacity for the size of the first area, for example having capacity to cover more details of the first area). In other words, the second model may have a correct spatial coverage for the first area. In other words, the capacity of a model (such as the capacity of the first model and/or the second model) and the size of an area (such as the size of the first area and/or the second area) may be a trade-off between achievable capacity and accuracy with respect to resources (such as computational, storage, and/or battery resources of the one or more electronic devices).

The server device 400 is configured to obtain (such as receive, determine, generate and/or retrieve), such as by using the processor circuitry 402 and/or via the wireless interface 403, a third model for the second area. In other words, a third model may be assigned for the second area. The server device 400 may be configured to obtain one or more models for a plurality of areas included in the first area (such as one or more of the areas that the first area has been split into). In other words, the server device 400 may be configured to assign one or more models for a plurality of areas included in the first area. For example, the server device 400 may be configured to obtain a fifth model for a third area, a sixth model for a fourth area, a seventh model for a fifth area, etc. The server device 400 may be configured to obtain at least 5 models for 5 areas, at least 10 models for 10 areas, at least 20 models for 20 areas, at least 50 models for 50 areas, at least 100 models for 100 areas, and/or at least 500 models for 500 areas. The third model may be based on one or more of: the first model, the second model, the first operational data, the first performance parameter, the second performance parameter, and the model performance parameter. In other words, the server device 400 may be configured to assign a new model to each new area that the first area has been divided into (such as split into).

In one or more example server devices and/or electronic devices, the server device 400 is configured to transmit (such as sending using the processor circuitry 402 and/or via the wireless interface 403, for example distributing the third model) the third model to the one or more second electronic devices (such as electronic devices 300, 300A of Fig. 1) associated with the second area. In other words, the server device 400 may be configured to distribute the third model to the one or more electronic devices associated with the second area.

In one or more example server devices, the server device 400 (such as using the processor circuitry 402) is configured to determine, based on the first model and/or the second model, one or more first operation schemes for the one or more first electronic devices. For example, the server device 400 (such as using the processor circuitry 402) may be configured to determine one or more transmission schemes, such as including a transmission power configuration, a control scheme for one or more electronic devices (such as the one or more first electronic devices and/or the one or more second electronic devices). For example, the server device 400 may be configured to determine one or more operation schemes (such as transmission schemes) for an IoT system, such as for farming, tracking or the like.

In one or more example server devices, one or more of the first model, the second model, and/or the third model are configured to predict one or more configurations of a corresponding operation scheme, such as corresponding to the model being used. In other words, one or more of the first model, the second model, and/or the third model may be configured to predict one or more operational parameters for one or more electronic devices, such as one or more electronic devices being associated with an area assigned the corresponding model (such as the one or more first electronic devices being assigned with the first model and/or the second model for the first area). For example, in certain areas where radio conditions are poor, a large amount of transmitting energy may be consumed by an electronic device by searching, connecting, and/or transmitting. The present disclosure may therefore provide a more power efficient operation of electronic devices (for example by predicting transmission energy based on sensed radio conditions).

In one or more example server devices, the server device 400 is configured to obtain (such as receive, determine, generate and/or retrieve), such as using the processor circuitry 402 and/or via the wireless interface 403, second operational data associated with the second area (such as associated with a second set of coordinates), from one or more second electronic devices (such as electronic device 300 and/or 300A of Fig. 1). Second operational data associated with the second area may be seen as operational data being indicative of one or more conditions of one or more parameters for the one or more second electronic devices in the second area. For example, the second operational data associated with the second area may be indicative of a radio condition of the one or more electronic devices in the second area.

In one or more example server devices, the second operational data comprises sensor data and/or radio parameter data. The radio parameter data may for example comprise sensed radio conditions (such as signal strength and/or transmission power and/or energy) by the one or more electronic devices in the second area. The radio parameter data may comprise a signal strength indicator (such as level and/or intensity), a channel quality indicator, CQI, a timing advance value, an error rate parameter, and a difference in signal strength. The radio parameter data may comprise a signal-to-interference-plus-noise ratio, SINR, a reference signal received power, RSRP, a reference signal received quality, RSRQ, and/or a timing advance value, TA. A signal strength indicator may for example comprise a received signal strength indication, RSSI, and/or channel state information, CSI. An error rate parameter may for example comprise a bit error rate, BER, a frame error rate, FER, and/or a block error rate, BLER. The sensor data may comprise one or more of position data (such as tuples of coordinates), movement data, temperature data, and/or light data.

In one or more example server devices, the server device 400 is configured to determine a fourth model, such as using the processor circuitry 402, based on the second operational data, the first model, the second model, and/or the third model. In other words, the server device 400 (such as on a cloud server) may be configured to update the first model for the second area based on the second operational data associated with the second area. For example, the server device 400 may be configured to update the third model for the second area based on the second operational data associated with the second set of coordinates to provide the fourth model, such as based on the second operational data from the one or more second electronic devices. The fourth model may be seen as an updated third model, such as a trained and/or re-trained third model.

In one or more example server devices, the determination of the fourth model is based on a training and/or re-training of the third model. In other words, the server device 400 may be configured to train and/or re-train the third model based on the second operational data. For example, the server device 400 may determine the fourth model by training and/or re-training the first model, to predict fourth operational data (such as updated second operational data) based on the second operational data.

In one or more example server devices, the determination of the fourth model is based on the sensor data and/or radio parameter data. The server device 400 may for example predict fourth operational data (such as predicted transmission power) based the sensor data and/or the radio parameter data (such as sensed radio conditions).

In one or more example server devices, the server device 400 (such as using the processor circuitry 402) is configured to determine, based on the third model and/or the fourth model, one or more second operation schemes for the one or more second electronic devices associated with the second area.

In one or more example server devices and/or electronic devices, the server device 400 is configured to transmit (such as sending using the processor circuitry 402 and/or via the wireless interface 403, for example distributing the third model) the fourth model to the one or more second electronic devices (such as electronic devices 300, 300A) associated with the second area. In other words, the server device 400 may be configured to distribute the fourth model to the one or more second electronic devices associated with the second area.

In one or more example server devices, the server device 400 is configured to repeat for further areas, the obtaining of operational data, the determination of a model, the obtaining of one or more performance parameters, the obtaining of model performance parameter, the determination of whether the model performance parameter satisfies a first criterion, the determination of whether the one or more performance parameters satisfies a second criterion, the determination of an area, and/or the obtaining of a model (such as an updated model), in order to adapt the size of an area to a model (such as adapt a size of an area to a model based on a complexity of an area).

Processor circuitry 402 is optionally configured to perform any of the operations disclosed in Figs. 3A-3C (such as any one or more of S102A, S105, S106A, S106B, S121, S122, S124, S126, S128, S130, S132, S134, S136). The operations of the server device 400 may be embodied in the form of executable logic routines (for example, lines of code, software programs, etc.) that are stored on a non-transitory computer readable medium (for example, memory circuitry 401) and are executed by processor circuitry 402.

Furthermore, the operations of the server device 400 may be considered a method that the server device 400 is configured to carry out. Also, while the described functions and operations may be implemented in software, such functionality may also be carried out via dedicated hardware or firmware, or some combination of hardware, firmware and/or software.

Memory circuitry 401 may be one or more of a buffer, a flash memory, a hard drive, a removable media, a volatile memory, a non-volatile memory, a random access memory (RAM), or other suitable device. In a typical arrangement, memory circuitry 401 may include a non-volatile memory for long term data storage and a volatile memory that functions as system memory for processor circuitry 402. Memory circuitry 401 may exchange data with processor circuitry 402 over a data bus. Control lines and an address bus between memory circuitry 401 and processor circuitry 402 also may be present (not shown in Fig. 2). Memory circuitry 401 is considered a non-transitory computer readable medium.

Memory circuitry 401 may be configured to store information such as a model (first model, second model, third model, fourth model), operational data, performance parameters, areas (such as sets of coordinates of one or more areas) in a part of the memory.

Fig. 3A-3C shows a flow diagram of an example method 100, performed by a server device according to the disclosure. The method 100 may be performed for providing model performance parameter. The method 100 may be performed for spatial modelling. The method 100 may be performed for spatial mapping of a model. The method 100 may be performed for controlling and/or updating a model for operations of an electronic device. The method 100 may be performed by a server device disclosed herein, such as server device 400 of Fig. 1, and Fig. 2.

The method 100 comprises obtaining S102 a first model for a first area.

The method 100 comprises obtaining S104 first operational data associated with the first area, from the one or more first electronic devices.

The method 100 comprises determining S106 a second model, based on the first operational data and the first model.

The method 100 comprises obtaining S108 a first performance parameter indicative of a performance of the first model.

The method 100 comprises obtaining S110 a second performance parameter indicative of a performance of the second model.

The method 100 comprises determining S112 a model performance parameter based on the first performance parameter and the second performance parameter.

The method 100 comprises determining S114 whether the model performance parameter satisfies a first criterion.

The method 100 comprises, when the model performance parameter does not satisfy the first criterion, determining S116 whether the second performance parameter satisfies a second criterion.

The method 100 comprises, when the model performance parameter does not satisfy the first criterion, and when the second performance parameter does not satisfy the second criterion, determining S118 a second area, the second area being smaller than the first area.

The method 100 comprises, when the model performance parameter does not satisfy the first criterion, and when the second performance parameter does not satisfy the second criterion, obtaining S120 a third model for the second area.

In one or more example methods, the determining S106 of the second model comprises training and/or re-training 106A of the first model.

In one or more example methods, the determining S106 of the second area comprises applying S106B one or more of: clustering one or more elements of the first area and encoding the second area into an alphanumeric string.

In one or more example methods, the first operational data comprises sensor data and/or radio parameter data.

In one or more example methods, the determination S106 of the second model is based on the sensor data and/or radio parameter data.

In one or more example methods, when the model performance parameter satisfies the first criterion, the method 100 comprises refraining S122 from determining whether the second performance parameter satisfies a second criterion.

In one or more example methods, when the second performance parameter satisfies the second criterion, the method 100 comprises refraining S124 from determining the second area.

In one or more example methods, the method 100 comprises determining S126 based on the first model and/or the second model, one or more first operation schemes for the one or more first electronic devices.

In one or more example methods, the first criterion comprises a first threshold.

In one or more example methods, the second criterion comprises a second threshold.

In one or more example methods, the obtaining S102 of the first model comprises associating S102A the first model with the first area.

In one or more example methods, the second area is part of a plurality of areas included in the first area.

In one or more example methods, the method 100 comprises predicting S128, using one or more of the first model, the second model, and the third model, one or more configurations of a corresponding operation scheme.

In one or more example methods, the method 100 comprises transmitting S130 the first model to the one or more first electronic devices associated with the first area.

In one or more example methods, the method 100 comprises transmitting S132 the third model to the one or more second electronic devices associated with the second area.

In one or more example methods, the method 100 comprises obtaining S105 second operational data, from one or more second electronic devices associated with the second area.

In one or more example methods, the second operational data is associated with the second area.

In one or more example methods, the method 100 comprises determining S121 a fourth model, based on the second operational data and the third model.

In one or more example methods, the method 100 comprises transmitting S134 the fourth model to the one or more second electronic devices.

In one or more example methods, the method 100 comprises determining S136, based on the third model and/or the fourth model, one or more second operation schemes for the one or more second electronic devices.

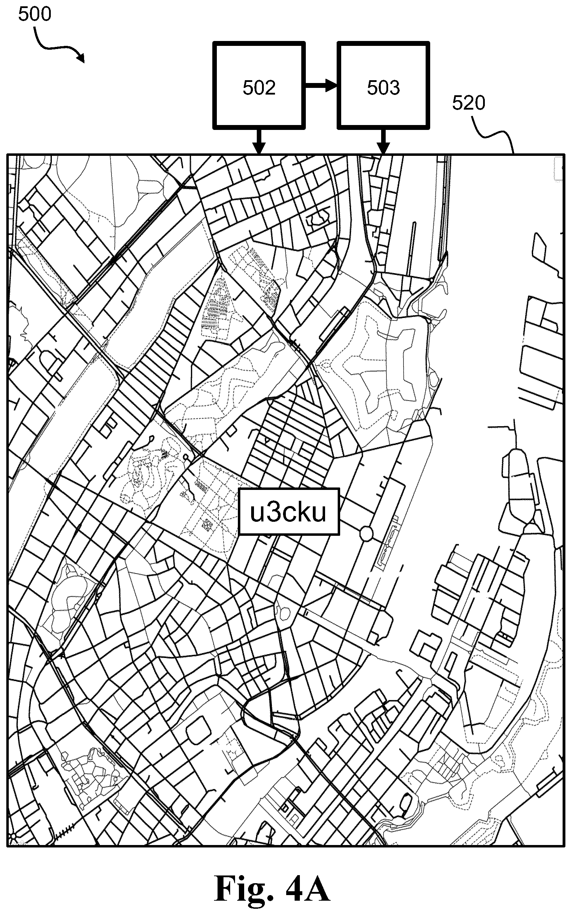

Fig. 4A is a schematic representation 500 illustrating an example first area 520 and an example first model 502 for the first area 520. The server device disclosed herein, (such as server device 400 of Fig. 1 and 2) may be configured to assign the first model 502 for the first area 520.

The first area 520 may be encoded with an alphanumeric string (illustrated by string "u3cku"). In Fig. 4A, the first area 520 corresponds to a city (such as part of a city). The server device is configured to obtain first operational data associated with the first area 520, from one or more first electronic devices, that may be deployed or located in the first area 520. The one or more first electronic devices may be associated with the first area 520.

The server device is configured to determine a second model 503, based on the first operational data and the first model 502, for example based on training or retraining the first model 502. The server device is configured to obtain a first performance parameter indicative of a performance of the first model 502. The server device is configured to obtain a second performance parameter indicative of a performance of the second model 503. The server device is configured to determine a model performance parameter based on the first performance parameter and the second performance parameter. The server device is configured to determine whether the model performance parameter satisfies a first criterion. The server device is configured to, when the model performance parameter does not satisfy the first criterion, determine whether the second performance parameter satisfies a second criterion.

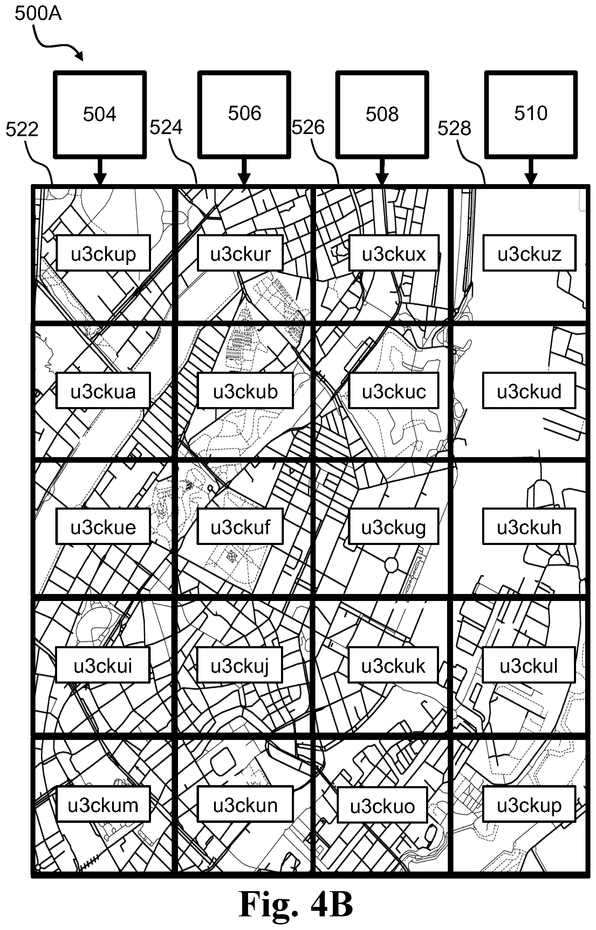

Fig. 4B is a schematic representation 500A illustrating an example second area 522.The second area 522 is for example smaller than the first area 520 (such as first area 520 of Fig. 4A). The server device is configured to determine a second area 522 by clustering and/or splitting and/or encoding the first area 520. The second area 522 is for example smaller than the first area 520. The server device is configured to, when the second performance parameter does not satisfy the second criterion, determine a second area 522, the second area 522 being smaller than the first area (such as first area 520 of Fig. 4A). The server device (is configured to obtain a third model 504 for the second area 522. The second area 522 may be encoded with an alphanumeric string (here "u3ckup", such as applying a geohashing function).

In one or more example server devices, the server device (such as server device 400, for example using the processor circuitry 402) may be configured to, when the second performance parameter does not satisfy the second criterion, determine a third area 524. The third area 524 is for example smaller than the first area (such as first area 520 of Fig. 4A). In one or more example server devices, the server device may be configured to, when the second performance parameter does not satisfy the second criterion, repeat the determination of an area (such as a plurality of areas illustrated in Fig. 4B) being smaller than the first area (such as first area 520 of Fig. 4A). For example, the server device may be configured to determine a fourth area 526 being smaller than the first area (such as first area 520 of Fig. 4A) and/or a fifth area 528 being smaller than the first area (such as first area 520 of Fig. 4A).

In one or more example server devices, the server device (is configured to obtain a fifth model 506 for the third area 524, a sixth model 508 for the fourth area 526, a seventh model 510 for a fifth area 528. In other words, the server device may be configured to assign a new model to each new area that the first area (such as first area 520 of Fig. 4A) has been divided into (such as split into). In Fig. 4B, the first area (such as first area 520 of Fig. 4A) has been divided into substantially equal sized areas and each area has been encoded with an alphanumeric string (such as each areas having a different alphanumeric string, for example applying a geohashing function). The areas in Fig. 4B (such as the second area 522 and the third area 524) have been determined as being substantially squared areas (such as of substantially the same size).

The third area 524 may be encoded with an alphanumeric string (here "u3ckur"), the fourth area 526 may be encoded with an alphanumeric string (here "u3ckux"), and/or the fifth area 528 may be encoded with an alphanumeric string (here "u3ckuz"). This may continue for the other areas with respective alphanumeric strings illustrated "u3ckua", "u3ckub", "u3ckuc", "u3ckud", "u3ckue", "u3ckuf", "u3ckug", "u3ckuh", "u3ckui", "u3ckuj", "u3ckuk", "u3ckul", "u3ckum", "u3ckun", "u3ckuo", and/or "u3ckup".

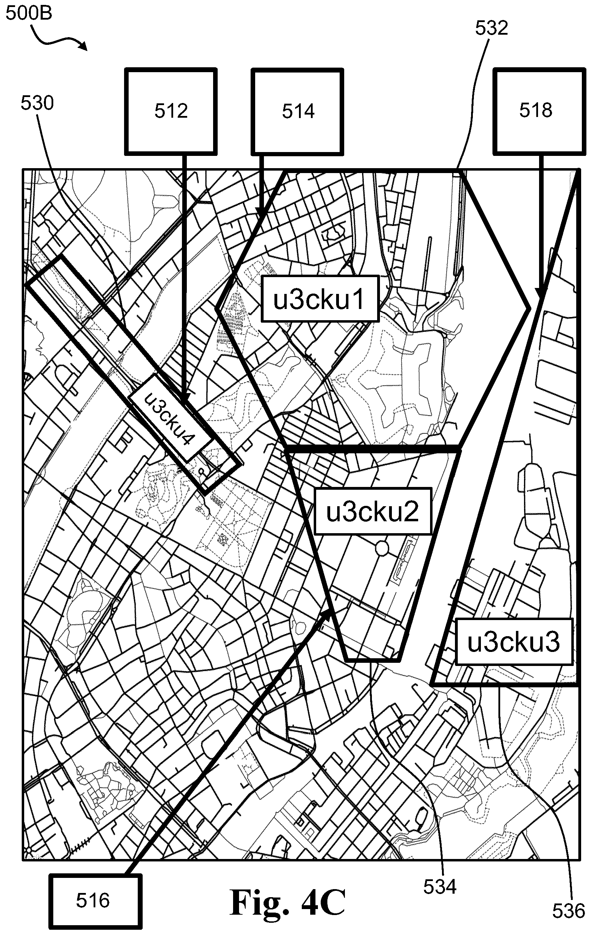

Fig. 4C is a schematic representation 500B illustrating an example second area 530. The second area 530 is for example smaller than the first area (such as first area 520 of Fig. 4A).

A server device as disclosed herein, (such as server device 400 of Fig. 1 and 2) may be configured to determine a second area 530. The second area 530 is for example smaller than the first area 520. The server device is configured to, when the second performance parameter does not satisfy the second criterion, determine a second area 530. For example, the second area 530 is smaller than the first area (such as first area 520 of Fig. 4A). The server device may be configured to obtain a third model 512 for the second area 530. The second area 530 may be determined by clustering one or more elements of the first area (such as first area 520 of Fig. 4A, for example applying a clustering algorithm).

The second area 530 may be encoded with an alphanumeric string (here "u3cku4", such as applying a geohashing function).

In one or more example server devices, the server device may be configured to, when the second performance parameter does not satisfy the second criterion, determine a third area 532, the third area 532 being smaller than the first area 520. In one or more example server devices, the server may be configured to, when the second performance parameter does not satisfy the second criterion, repeat the determination of an area (such as a plurality of areas) being smaller than the first area 520. For example, the server device may be configured to determine a fourth area 534 being smaller than the first area 520 and/or a fifth area 536 being smaller than the first area 520.

In one or more example server devices, the server device is configured to obtain a fifth model 514 for the third area 532, a sixth model 516 for the fourth area 534, a seventh model 518 for a fifth area 536. In other words, the server device may be configured to assign a new model to each new area that the first area 520 has been divided into (such as split into). In Fig. 4C, the first area 520 has been divided into areas having different sizes. The areas in Fig. 4C (such as the second area 530 and the third area 532) have been determined as having different shapes and sizes (such as different polygons of different sizes). For example, the second area 530 has a rectangular shape (for example, associated with a junction and/or a section of a road). For example, the second area 530 is smaller than the third area 532 which has a hexagonal shape, the fourth area 534 has a shape of a polygon with four sides, and the fifth area 536 has a triangular shape. In other words, the server device (such as server device 400) may be configured to divide the first area 520 into one or more clusters (such as comprising the second area 530, the third area 532, the fourth area 534, and/or the fifth area 536) which may be different in size and shape.

The determination of the second area 530 (such as the determination of the size and shape of the second area 530) may be based on one or more parameters. For example, the one or more parameters may be indicative of one or more of: spatial and/or geometric complexity. For example, the determination of the second area 530 (such as the determination of the size and shape of the second area 530) may be based on traffic (such as data traffic and/or vehicle traffic) in the second area 530, complexity of the second area 530, and/or a number of electronic devices associated with the second area 530 (such as the number of electronic devices present in the second area). In other words, the determination of the second area 530 by applying clustering of one or more elements of the first area may be based on one or more parameters as described above. For example, the second area 530 may be smaller than the third area 532 because the second area 530 has a larger complexity than the third area 532, the second area 530 has a larger number of electronic devices than the third area 532, and/or the second area 530 has more traffic than the third area 532.

In one or more example server devices, each area may have been encoded with an alphanumeric string (such as each areas having a different alphanumeric string, for example using a geohashing function).

The third area 532 may be encoded with an alphanumeric string (here "u3cku1"), the fourth area 534 may be encoded with an alphanumeric string (here "u3cku2"), and/or the fifth area 536 may be encoded with an alphanumeric string (here "u3cku3").

The use of the terms "first", "second", "third" and "fourth", "primary", "secondary", "tertiary" etc. does not imply any particular order, but are included to identify individual elements. Moreover, the use of the terms "first", "second", "third" and "fourth", "primary", "secondary", "tertiary" etc. does not denote any order or importance, but rather the terms "first", "second", "third" and "fourth", "primary", "secondary", "tertiary" etc. are used to distinguish one element from another. Note that the words "first", "second", "third" and "fourth", "primary", "secondary", "tertiary" etc. are used here and elsewhere for labelling purposes only and are not intended to denote any specific spatial or temporal ordering. Furthermore, the labelling of a first element does not imply the presence of a second element and vice versa.

It may be appreciated that Figures 1-4C comprise some circuitries or operations which are illustrated with a solid line and some circuitries, components, features, or operations which are illustrated with a dashed line. Circuitries or operations which are comprised in a solid line are circuitries, components, features or operations which are comprised in the broadest example. Circuitries, components, features, or operations which are comprised in a dashed line are examples which may be comprised in, or a part of, or are further circuitries, components, features, or operations which may be taken in addition to circuitries, components, features, or operations of the solid line examples. It should be appreciated that these operations need not be performed in order presented. Furthermore, it should be appreciated that not all of the operations need to be performed. The example operations may be performed in any order and in any combination. It should be appreciated that these operations need not be performed in order presented. Circuitries, components, features, or operations which are comprised in a dashed line may be considered optional.

Other operations that are not described herein can be incorporated in the example operations. For example, one or more additional operations can be performed before, after, simultaneously, or between any of the described operations.

Certain features discussed above as separate implementations can also be implemented in combination as a single implementation. Conversely, features described as a single implementation can also be implemented in multiple implementations separately or in any suitable sub-combination. Moreover, although features may be described above as acting in certain combinations, one or more features from a claimed combination can, in some cases, be excised from the combination, and the combination may be claimed as any sub-combination or variation of any sub-combination

It is to be noted that the word "comprising" does not necessarily exclude the presence of other elements or steps than those listed.

It is to be noted that the words "a" or "an" preceding an element do not exclude the presence of a plurality of such elements.

It should further be noted that any reference signs do not limit the scope of the claims, that the examples may be implemented at least in part by means of both hardware and software, and that several "means", "units" or "devices" may be represented by the same item of hardware.

Language of degree used herein, such as the terms "approximately," "about," "generally," and "substantially" as used herein represent a value, amount, or characteristic close to the stated value, amount, or characteristic that still performs a desired function or achieves a desired result. For example, the terms "approximately", "about", "generally," and "substantially" may refer to an amount that is within less than or equal to 10% of, within less than or equal to 5% of, within less than or equal to 1% of, within less than or equal to 0.1 % of, and within less than or equal to 0.01% of the stated amount. If the stated amount is 0 (e.g., none, having no), the above recited ranges can be specific ranges, and not within a particular % of the value.

The various example methods, devices, and systems described herein are described in the general context of method steps or processes, which may be implemented in one aspect by a computer program product, embodied in a computer-readable medium, including computer-executable instructions, such as program code, executed by computers in networked environments. A computer-readable medium may include removable and non-removable storage devices including, but not limited to, Read Only Memory (ROM), Random Access Memory (RAM), compact discs (CDs), digital versatile discs (DVD), etc. Generally, program circuitries may include routines, programs, objects, components, data structures, etc. that perform specified tasks or implement specific abstract data types. Computer-executable instructions, associated data structures, and program circuitries represent examples of program code for executing steps of the methods disclosed herein. The particular sequence of such executable instructions or associated data structures represents examples of corresponding acts for implementing the functions described in such steps or processes.

Although features have been shown and described, it will be understood that they are not intended to limit the claimed disclosure, and it will be made obvious to those skilled in the art that various changes and modifications may be made without departing from the scope of the claimed disclosure. The specification and drawings are, accordingly, to be regarded in an illustrative rather than restrictive sense.

## Claims

1. A server device (400) comprising memory circuitry (401), one or more interfaces (403), and processor circuitry (402), wherein the server device (400) is configured to:
- obtain a first model for a first area;
- obtain first operational data associated with the first area, from one or more first electronic devices;
- determine a second model, based on the first operational data and the first model, wherein the determination of the second model comprises updating the first model for the first area based on the first operational data associated with the first area;
- obtain a first performance parameter indicative of a performance of the first model;
- obtain a second performance parameter indicative of a performance of the second model;
- determine a model performance parameter based on the first performance parameter and the second performance parameter;
- determine whether the model performance parameter satisfies a first criterion;
- wherein the processor circuitry is configured to, when the model performance parameter does not satisfy the first criterion:
▪ determine whether the second performance parameter satisfies a second criterion;
▪ when the second performance parameter does not satisfy the second criterion, the processor circuitry is configured to:
• determine a second area, wherein the second area is a division of the first area and the second area being smaller than the first area; and
• obtain a third model for the second area,
wherein the first model, the second model, and the third model are machine learning models configured to provide one or more configurations of one or more operational parameters for one or more electronic devices located in an area.

2. The server device according to claim 1, wherein the determination of the second model is based on a training and/or re-training of the first model.

3. The server device according to any of the previous claims, wherein the determination of the second area comprises applying one or more of: clustering one or more elements of the first area, and encoding the second area into an alphanumeric string.

4. The server device according to any of the previous claims, wherein the first operational data comprises sensor data and/or radio parameter data.

5. The server device according to claim 4, wherein the determination of the second model is based on the sensor data and/or radio parameter data.

6. The server device according to any of the previous claims, wherein the processor circuitry is configured to, when the model performance parameter satisfies the first criterion, refrain from determining whether the second performance parameter satisfies a second criterion.

7. The server device according to any of the previous claims, wherein the processor circuitry is configured to, when the second performance parameter satisfies the second criterion, refrain from determining the second area.

8. The server device according to any of the previous claims, wherein the processor circuitry is configured to determine, based on the first model and/or the second model, one or more first operation schemes for the one or more first electronic devices.

9. The server device according to any of the previous claims, wherein the first criterion comprises a first threshold.

10. The server device according to any of the previous claims, wherein the second criterion comprises a second threshold.

11. The server device according to any of the previous claims, wherein the obtaining of the first model is based on an association of the first model with the first area.

12. The server device according to any of the previous claims, wherein the second area is part of a plurality of areas included in the first area.

13. The server device according to any of the previous claims, wherein one or more of the first model, the second model, and/or the third model are configured to predict one or more configurations of a corresponding operation scheme.

14. The server device according to any of the previous claims, wherein the processor circuitry is configured to transmit the first model to the one or more first electronic devices associated with the first area.

15. The server device according to any of the previous claims, wherein the processor circuitry is configured to transmit the third model to one or more second electronic devices associated with the second area.

## Patentansprüche

1. Servervorrichtung (400), die eine Speicherschaltung (401), eine oder mehrere Schnittstellen (403) und eine Prozessorschaltung (402) umfasst, wobei die Servervorrichtung (400) konfiguriert ist, um:
- ein erstes Modell für einen ersten Bereich aufzunehmen;
- von einer oder mehreren ersten elektronischen Vorrichtung(en) erste Betriebsdaten aufzunehmen, die dem ersten Bereich zugeordnet sind, ;
- ein zweites Modell auf der Grundlage der ersten Betriebsdaten und des ersten Modells zu bestimmen, wobei das Bestimmen des zweiten Modells das Aktualisieren des ersten Modells für den ersten Bereich auf der Grundlage der dem ersten Bereich zugeordneten ersten Betriebsdaten umfasst;
- einen ersten Leistungsparameter aufzunehmen, der eine Leistung des ersten Modells angibt;
- einen zweiten Leistungsparameter aufzunehmen, der eine Leistung des zweiten Modells angibt;
- einen Modellleistungsparameter basierend auf dem ersten Leistungsparameter und dem zweiten Leistungsparameter zu bestimmen;
- zu bestimmen, ob der Modellleistungsparameter ein erstes Kriterium erfüllt;
- wobei die Prozessorschaltung konfiguriert ist, um, wenn der Modellleistungsparameter das erste Kriterium nicht erfüllt:
▪ zu bestimmen, ob der zweite Leistungsparameter ein zweites Kriterium erfüllt;
▪ wenn der zweite Leistungsparameter das zweite Kriterium nicht erfüllt, ist die Prozessorschaltung konfiguriert, um:
• einen zweiten Bereich zu bestimmen, wobei der zweite Bereich eine Unterteilung des ersten Bereichs und der zweite Bereich kleiner als der erste Bereich ist; und
• ein drittes Modell für den zweiten Bereich aufzunehmen, wobei das erste Modell, das zweite Modell und das dritte Modell Maschinenlernmodelle sind, die dazu konfiguriert sind, eine oder mehrere Konfiguration(en) eines oder mehrerer Betriebsparameter(s) für eine oder mehrere in einem Bereich angeordnete elektronische Vorrichtung(en) bereitzustellen.

2. Servervorrichtung gemäß Anspruch 1, wobei das Bestimmen des zweiten Modells auf einem Training und/oder erneuten Training des ersten Modells basiert.

3. Servervorrichtung gemäß einem der vorhergehenden Ansprüche, wobei das Bestimmen des zweiten Bereichs das Anwenden eines oder mehrerer der folgenden Schritte umfasst: Clustern eines oder mehrerer Elemente des ersten Bereichs und Kodieren des zweiten Bereichs in eine alphanumerische Zeichenfolge.

4. Servervorrichtung gemäß einem der vorhergehenden Ansprüche, wobei die ersten Betriebsdaten Sensordaten und/oder Funkparameterdaten umfassen.

5. Servervorrichtung gemäß Anspruch 4, wobei das Bestimmen des zweiten Modells auf den Sensordaten und/oder Funkparameterdaten basiert.

6. Servervorrichtung gemäß einem der vorhergehenden Ansprüche, wobei die Prozessorschaltung konfiguriert ist, um für den Fall, dass der Modellleistungsparameter das erste Kriterium erfüllt, davon abzusehen zu bestimmen, ob der zweite Leistungsparameter ein zweites Kriterium erfüllt.

7. Servervorrichtung gemäß einem der vorhergehenden Ansprüche, wobei die Prozessorschaltung konfiguriert ist, um für den Fall, dass der zweite Leistungsparameter das zweite Kriterium erfüllt, davon abzusehen, den zweiten Bereich zu bestimmen.

8. Servervorrichtung gemäß einem der vorhergehenden Ansprüche, wobei die Prozessorschaltung konfiguriert ist, um basierend auf dem ersten Modell und/oder dem zweiten Modell ein oder mehrere erste Betriebsschemata für die eine oder die mehreren erste(n) elektronische(n) Vorrichtung(en) zu bestimmen.

9. Servervorrichtung gemäß einem der vorhergehenden Ansprüche, wobei das erste Kriterium einen ersten Schwellenwert umfasst.

10. Servervorrichtung gemäß einem der vorhergehenden Ansprüche, wobei das zweite Kriterium einen zweiten Schwellenwert umfasst.

11. Servervorrichtung gemäß einem der vorhergehenden Ansprüche, wobei das Aufnehmen des ersten Modells auf einer Zuordnung des ersten Modells zum ersten Bereich basiert.

12. Servervorrichtung gemäß einem der vorhergehenden Ansprüche, wobei der zweite Bereich Teil einer Vielzahl von Bereichen ist, die im ersten Bereich enthalten sind.

13. Servervorrichtung gemäß einem der vorhergehenden Ansprüche, wobei eines oder mehrere des ersten Modells, des zweiten Modells und/oder des dritten Modells dazu konfiguriert sind, eine oder mehrere Konfiguration(en) eines entsprechenden Betriebsschemas vorhersagen.

14. Servervorrichtung gemäß einem der vorhergehenden Ansprüche, wobei die Prozessorschaltung konfiguriert ist, um das erste Modell an die eine oder die mehreren erste(n) elektronische(n) Vorrichtung(en) zu übertragen, die dem ersten Bereich zugeordnet sind.

15. Servervorrichtung gemäß einem der vorhergehenden Ansprüche, wobei die Prozessorschaltung konfiguriert ist, um das dritte Modell an die eine oder die mehreren zweite(n) elektronische(n) Vorrichtung(en) zu übertragen, die dem zweiten Bereich zugeordnet sind.

## Revendications

1. Dispositif de serveur (400) comprenant un circuit de mémoire (401), une ou des interfaces (403) et un circuit de processeur (402), dans lequel le dispositif de serveur (400) est configuré pour :
- obtenir un premier modèle pour une première zone ;
- obtenir les premières données opérationnelles associées à la première zone, à partir d'un ou des premiers dispositifs électroniques ;
- déterminer un deuxième modèle, sur la base des premières données opérationnelles et du premier modèle, dans lequel la détermination du deuxième modèle consiste à mettre à jour le premier modèle pour la première zone sur la base des premières données opérationnelles associées à la première zone ;
- obtenir un premier paramètre de performance indiquant la performance du premier modèle ;
- obtenir un second paramètre de performance indiquant la performance du deuxième modèle ;
- déterminer un paramètre de performance du modèle sur la base du premier paramètre de performance et du second paramètre de performance ;
- déterminer si le paramètre de performance du modèle satisfait à un premier critère ;
- dans lequel le circuit du processeur est configuré pour, lorsque le paramètre de performance du modèle ne satisfait pas au premier critère :
▪ déterminer si le second paramètre de performance satisfait à un second critère ;
▪ lorsque le second paramètre de performance ne satisfait pas au second critère, le circuit du processeur est configuré pour :
▪ déterminer une seconde zone, la seconde zone étant une division de la première zone et la seconde zone étant plus petite que la première ; et
▪ obtenir un troisième modèle pour la seconde zone, dans lequel le premier modèle, le deuxième modèle et le troisième modèle sont des modèles d'apprentissage automatique configurés pour fournir une ou des configurations d'un ou des paramètres opérationnels pour un ou des dispositifs électroniques situés dans une zone.

2. Dispositif de serveur selon la revendication 1, dans lequel la détermination du deuxième modèle est basée sur un entraînement et/ou un nouvel entraînement du premier modèle.

3. Dispositif de serveur selon l'une quelconque des revendications précédentes, dans lequel la détermination de la seconde zone comprend l'application d'un ou des éléments suivants : regroupement d'un ou des éléments de la première zone, et codage de la seconde zone dans une chaîne alphanumérique.

4. Dispositif de serveur selon l'une quelconque des revendications précédentes, dans lequel les premières données opérationnelles comprennent des données de capteurs et/ou des données de paramètres radio.

5. Dispositif de serveur selon la revendication 4, dans lequel la détermination du deuxième modèle est basée sur les données du capteur et/ou les données des paramètres radio.

6. Dispositif de serveur selon l'une quelconque des revendications précédentes, dans lequel le circuit du processeur est configuré pour, lorsque le paramètre de performance du modèle satisfait au premier critère, s'abstenir de déterminer si le second paramètre de performance satisfait à un second critère.

7. Dispositif de serveur selon l'une quelconque des revendications précédentes, dans lequel le circuit du processeur est configuré pour, lorsque le second paramètre de performance satisfait au second critère, s'abstenir de déterminer la seconde zone.

8. Dispositif de serveur selon l'une quelconque des revendications précédentes, dans lequel le circuit du processeur est configuré pour déterminer, sur la base du premier modèle et/ou du deuxième modèle, un ou des premiers schémas de fonctionnement pour un ou des premiers dispositifs électroniques.

9. Dispositif de serveur selon l'une quelconque des revendications précédentes, dans lequel le premier critère comprend un premier seuil.

10. Dispositif de serveur selon l'une quelconque des revendications précédentes, dans lequel le second critère comprend un second seuil.

11. Dispositif de serveur selon l'une quelconque des revendications précédentes, dans lequel l'obtention du premier modèle est basée sur une association du premier modèle avec la première zone.

12. Dispositif de serveur selon l'une quelconque des revendications précédentes, dans lequel la seconde zone fait partie d'une pluralité de zones incluses dans la première zone.

13. Dispositif de serveur selon l'une quelconque des revendications précédentes, dans lequel un ou des premier, deuxième et/ou troisième modèles sont configurés pour prédire une ou des configurations d'un schéma d'opération correspondant.

14. Dispositif de serveur selon l'une quelconque des revendications précédentes, dans lequel le circuit du processeur est configuré pour transmettre le premier modèle à un ou des premiers dispositifs électroniques associés à la première zone.

15. Dispositif de serveur selon l'une quelconque des revendications précédentes, dans lequel le circuit du processeur est configuré pour transmettre le troisième modèle à un ou des seconds dispositifs électroniques associés à la seconde zone.
